# EUROPÄISCHE PATENTANMELDUNG

(11) **EP 1 154 490 A2**
(43) Veröffentlichungstag der Anmeldung: **14.11.2001**
(21) Anmeldenummer: 01110453.6
(22) Anmeldetag: 27.04.2001
(51) Int. Cl.: H01L 29/08, H01L 29/78

(54) **Halbleiter-Leistungsbauelement mit reduziertem parasitärem Bipolartransistor**

(30) Priorität: 11.05.2000 DE 10023115
(71) Anmelder: Infineon Technologies AG, 81669 München (DE)
(72) Erfinder: Pfirsch, Frank, Dr., 81545 München (DE)
(74) Vertreter: MÜLLER & HOFFMANN Patentanwälte

(57) **Zusammenfassung**

Die Erfindung betrifft ein Halbleiter-Leistungsbauelement mit MOS-Struktur bei dem zur Verringerung der Verstärkung eines parasitären Bipolartransistors der Sourcebereich (4) aus einem Material besteht, dessen Bandlücke kleiner ist als diejenige des Materials des Kanalbereiches (3).

## Beschreibung

Die vorliegende Erfindung bezieht sich auf ein Halbleiter-Leistungsbauelement mit einem Sourcebereich, einem Drainbereich, einem zwischen Sourcebereich und Drainbereich vorgesehenen Kanalbereich und einem im Abstand über dem Kanalbereich angeordneten isolierten Gate.

Halbleiter-Leistungsbauelemente, insbesondere Leistungs-MOS-Feldeffekttransistoren, beispielsweise DMOS-Feldeffekttransistoren, enthalten neben ihrer beabsichtigten und für ihre Anwendung als z.B. elektronischer Schalter wesentlichen MOS-Struktur des durch ein isoliertes Gate gesteuerten Feldeffekttransistors noch eine unerwünschte parasitäre Bipolartransistorstruktur. Wenn als Beispiel ein n-Kanal-MOS-Feldeffekttransistor betrachtet wird, dessen Sourcebereich und Drainbereich jeweils n-leitend sind und bei dem zwischen dem Sourcebereich und dem Drainbereich ein p-leitender Bodyoder Kanalbereich vorgesehen ist, so bilden hier der Sourcebereich, der Kanalbereich und der Drainbereich einen parasitären npn-Bipolartransistor.

Die Durchbruchspannung eines solchen parasitären Bipolartransistors ist bei offener Basis, was zu einem sogenannten U_{CEO}-Durchbruch führt, abhängig von der Verstärkung des Bipolartransistors in der Regel erheblich niedriger als die Durchbruchspannung des MOS-Feldeffekttransistors, also beispielsweise eines DMOS-Feldeffekttransistors. So kann die Durchbruchspannung des parasitären Bipolartransistors 50 % oder weniger von der Durchbruchspannung des eigentlichen DMOS-Feldeffekttransistors betragen.

Damit nun der Spannungsbereich des DMOS-Feldeffekttransistors bis zu dessen Durchbruchspannung ausgenutzt und gegebenenfalls die Durchbruchspannung des DMOS-Feldeffekttransistors erreicht werden kann, müssen der Kanalbereich und der Sourcebereich durch den Sourcekontakt miteinander kurzgeschlossen werden. Ein solcher Kurzschluß ist aber immer mit einem Serienwiderstand behaftet, welcher aus dem Bahnwiderstand im Kanalbereich besteht.

Dieser Bahnwiderstand im Kanalbereich führt bei einem n-Kanal-MOS-Feldeffekttransistor dazu, daß bei hohen Löcherstromdichten, wie sie in einem Avalanchefall oder bei einem schnellen Spannungsanstieg am pn-Übergang insbesondere nach einem Fluten der Inversdiode mit Überschußladungsträgern auftreten können, der pn-Übergang zwischen dem Sourcebereich und dem Kanalbereich dennoch in Vorwärtsrichtung gepolt wird. Dadurch wird der Kurzschluß zwischen dem Sourcebereich und dem Kanalbereich über den Sourcekontakt praktisch unwirksam, was die Spannung auf den U_{CEO}-Durchbruchspannungswert des Bipolartransistors zusammenbrechen läßt.

Der MOS-Feldeffekttransistor wird durch diesen Vorgang in der Regel zerstört, da das Gate seine steuernde Wirkung verliert und der Strom nicht mehr abgeschaltet werden kann. Dieser sogenannte "bipolare zweite Durchbruch" ist unter anderem auch in B. Jayant Baliga: Modern Power Devices, New York 1987, S. 314-316, erläutert.

Die oben aufgezeigte Problematik ist seit langem bekannt. Entsprechend gibt es zu ihrer Überwindung bereits eine Vielzahl von Ansätzen, die überwiegend darauf basieren, durch einen guten Kurzschluß zwischen Sourcebereich und Kanalbereich den maximal beherrschbaren Löcherstrom möglichst groß zu machen.

Ein großer Löcherstrom kann bei einem n-Kanal-MOS-Feldeffekttransistor erhalten werden, indem beispielsweise ein zusätzliches p-leitendes Gebiet mit hoher Leitfähigkeit unterhalb des Sourcebereiches vorgesehen wird, wie dies in US 4 809 047 vorgeschlagen ist. Ein anderer Weg besteht darin, für eine möglichst kurze Strecke zu sorgen, die der Löcherstrom im p-leitenden Kanalbereich lateral unter dem Sourcebereich fließen muß (vgl. US 4 767 722). In beiden obigen Fällen wird letztlich der Spannungsabfall unterhalb des Sourcebereiches bis zum Sourcekontakt minimiert.

Weiterhin wird in US 4 364 073 ein IGBT beschrieben, bei dem durch eine hohe Dotierung des Kanalbereiches und eine niedrige Dotierung des Sourcebereiches die Verstärkung eines parasitären npn-Bipolartransistors hinreichend klein gemacht wird, so daß zusammen mit der Verstärkung des den rückseitigen p-leitenden Anodenbereiches enthaltenden parasitären pnp-Transistors nicht die Thyristor-Zündbedingung erreicht wird.

Wie beispielsweise in US 4 620 211 beschrieben ist, besteht eine weitere Möglichkeit, die Verstärkung eines parasitären npn-Transistors zu verringern, darin, in den Kanalbereich unterhalb des Sourcebereiches eine Zone mit hoher Rekombinationsgeschwindigkeit, beispielsweise einen metallischen Kontakt, einzubringen. Dieses Vorgehen ist insbesondere für rückwärts sperrfähige Transistoren geeignet, die keinen Kurzschluß zwischen Sourcebereich und Kanalbereich enthalten, so daß der pn-Übergang zwischen Sourcebereich und Kanalbereich in Sperrichtung Spannung aufzunehmen vermag.

Bei integrierten Schaltungen in CMOS-Technik, sogenannten CMOS-ICs, bilden benachbarte n-Kanal-MOS-Feldeffekttransistoren und p-Kanal-MOS-Feldeffekttransistoren zusammen Thyristorstrukturen. Unter ungünstigen Bedingungen, beispielsweise hohen Temperaturen und einem plötzlichen Spannungsanstieg, kann in einer solchen Thyristorstruktur die Thyristorzündbedingung erfüllt sein, was zu einem schnellen Stromanstieg und zu einer Zerstörung der integrierten Schaltung führt. Es tritt ein sogenannter "Latch-up" auf. In US 4 728 998 und US 5 142 641 ist angegeben, wie durch Verringerung des Emitterwirkungsgrades der Sourcebereiche die Latchup-Erscheinung verhindert werden kann. Die Verringerung des Emitterwirkungsgrades wird dabei dadurch erreicht, daß die Sourcebereiche aus SiGe hergestellt werden.

Schließlich ist es aus US 5 216 271 bekannt, ein Material mit niedriger Bandlücke zu verwenden, um in BICMOS-Bauelementen niedrige Kontaktwiderstände zu erreichen.

Es ist Aufgabe der vorliegenden Erfindung, ein Halbleiter-Leistungsbauelement mit MOS-Feldeffekttransistorstruktur anzugeben, bei dem auf einfache Weise ein Einschalten eines parasitären Bipolartransistors zuverlässig vermieden wird.

Diese Aufgabe wird bei einem Halbleiter-Leistungsbauelement der eingangs genannten Art erfindungsgemäß dadurch gelöst, daß der Sourcebereich aus einem Material besteht, dessen Bandlücke kleiner ist als diejenige des Materials des Kanalbereiches.

Unter einem Halbleiter-Leistungsbauelement sollen dabei ein n-Kanal- bzw. ein p-Kanal-MOS-Feldeffekttransistor, wie insbesondere ein lateraler oder vertikaler DMOS-Transistor mit planarem Gate, ein Leistungstransistor mit Trenchgate, ein UMOS-Transistor oder entsprechende IGBTs, welche zwischen Drainbereich und Drainkontakt noch ein Dotierungsgebiet mit einem zur Draindotierung entgegengesetzten Leitungstyp enthalten, verstanden werden.

Der Kanalbereich hat dabei in der Regel einen Leitungstyp, der zu demjenigen des Sourcebereiches und des Drainbereiches entgegengesetzt ist. Er kann aber auch bei "normally-on"-Transistoren den gleichen Leitungstyp aufweisen.

Bei dem erfindungsgemäßen Halbleiter-Leistungsbauelement besteht also der Sourcebereich aus einem Halbleitermaterial mit einer kleineren Bandlücke als die Bandlücke, welche das Material im Kanal- oder Bodybereich hat. Da nämlich der Minoritätsladungsträgerstrom in dem Sourcebereich exponentiell von der Differenz der Bandlücken zwischen Kanalbereich und Sourcebereich abhängt, nimmt die Verstärkung des parasitären Bipolartransistors, also beispielsweise des parasitären npn-Transistors, entsprechend ab. Diese Abnahme beträgt etwa eine Größenordnung je 60 meV.

Auf diese Weise kann eine niedrige Verstärkung des parasitären Bipolartransistors erreicht werden, ohne für andere Eigenschaften des Leistungsbauelementes ungünstige Dotierungsverhältnisse wählen zu müssen. Bekanntlich würde beispielsweise eine hohe Dotierung im Kanalbereich zu einer hohen Einsatzspannung führen, während eine niedrige Dotierung im Sourcebereich einen hohen Kontaktwiderstand zur Folge hat.

Die Erfindung ist in vorteilhafter Weise auch auf Leistungs-MOS-Feldeffekttransistoren ohne Kurzschluß zwischen Sourcebereich und Kanalbereich anwendbar, bei denen so die schwierig zu realisierende Erzeugung einer Zone mit hoher Rekombinationsgeschwindigkeit vermieden werden kann.

Die Erfindung nutzt in vorteilhafter Weise den von Hetero-Bipolartransistoren (HBP) bekannten Effekt einer Vergrößerung der Transistorverstärkung durch Materialien mit unterschiedlicher Bandlücke in nun entgegengesetzter Richtung aus: durch Herstellung des Sourcebereiches aus einem Material mit kleinerer Bandlücke als diejenige des Materials des Kanalbereiches wird die Verstärkung des parasitären Bipolartransistors reduziert, um so hinsichtlich ihrer Robustheit verbesserte Halbleiter-Leistungsbauelemente, wie insbesondere Leistungs-MOS-Feldeffekttransistoren und IGBTs, zu ermöglichen.

Das erfindungsgemäße Halbleiter-Leistungsbauelement ist beispielsweise mit Hilfe der von Hetero-Bipolartransistoren bekannten Methoden einfach herstellbar. Hierfür kommen beispielsweise eine selektive Epitaxie oder eine Germanium-Implantation in Betracht, um den Sourcebereich aus SiGe bei einem Silizium-Leistungsbauelement herzustellen (vgl. hierzu auch US 5 216 271). Eine andere Möglichkeit zur Bildung einer SiGe-Schicht besteht in einer selektiven CVD.

Andere geeignete Kombinationen von Halbleitermaterialien sind außer der erwähnten Kombination von Si und SiGe noch Si und InAs, Si und InSb, SiGe und Ge, Ge und GeSn, GaAs und Ge, InP und GeSn, InP und InGaAs, InP und PbS, SiC und Si sowie InAs und PbSnSe.

Nachfolgend wird die Erfindung anhand der Zeichnungen näher erläutert. Es zeigen:
- Fig. 1: eine Schnittdarstellung eines Leistungs-MOS-Feldeffekttransistors als einem Ausführungsbeispiel der Erfindung, und
- Fig. 2: ein Ersatzschaltbild zu dem Feldeffekttransistor von Fig. 1.

Der Leistungs-MOS-Feldeffekttransistor umfaßt ein n⁺-leitendes Siliziumsubstrat 1, auf dem eine n-leitende Siliziumschicht 2 aufgetragen ist. In dieser Siliziumschicht 2 befindet sich ein p-leitender Kanal- bzw. Bodybereich 3 aus Silizium, in welchem wiederum ein n⁺-leitender Sourcebereich 4 aus SiGe enthalten ist.

Das Siliziumsubstrat 1 ist mit einem Drainkontakt 5 versehen, während auf dem Sourcebereich 4 und dem Kanalbereich 3 ein Sourcekontakt 6 angebracht ist. Schließlich ist noch in eine Isolierschicht 7 aus beispielsweise Siliziumdioxid eine Gateelektrode 8 aus beispielsweise polykristallinem Silizium eingebettet.

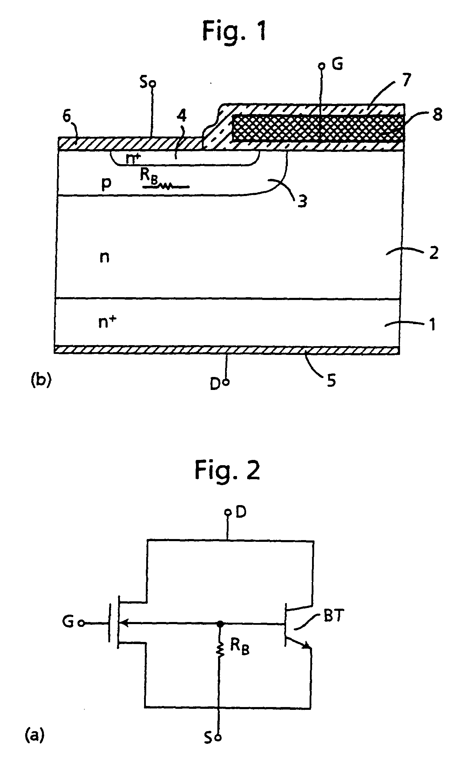

Fig. 2 zeigt ein Ersatzschaltbild des Leistungs-MOS-Feldeffekttransistors von Fig. 1 mit einem Sourceanschluß S, einem Gateanschluß G und einem Drainanschluß D. Der Bahnwiderstand des Kanalbereiches 3 ist durch R_{B} symbolisiert.

Durch die Verwendung eines Materiales mit kleiner Bandlücke für den Sourcebereich 4 kann die Verstärkung des parasitären Bipolartransistors BT aus dem Sourcebereich 4, dem Kanalbereich 3 und der Schicht 2 sowie dem Substrat 1 klein gemacht werden, so daß auch ein sehr hoher Löcherstrom nicht zum Einschalten des parasitären Bipolartransistors BT führt.

Die Bandlücke des Materials des Sourcebereiches sollte um wenigstens 0,1 eV kleiner als die Bandlücke des Materials des Kanalbereiches sein. Besonders vorteilhaft ist es, wenn die Bandlücke des Materials des Sourcebereiches um etwa 0,2 eV kleiner ist als die Bandlücke des Materials des Kanalbereiches.

### Bezugszeichenliste

- 1: Siliziumsubstrat
- 2: Siliziumschicht
- 3: Kanal- bzw. Bodybereich
- 4: Sourcebereich
- 5: Drainkontakt
- 6: Sourcekontakt
- 7: Isolierschicht
- 8: Gateelektrode
- S: Sourceanschluß
- D: Drainanschluß
- G: Gateanschluß
- BT: Bipolartransistor

## Patentansprüche

1. Halbleiter-Leistungsbauelement mit einem Sourcebereich (4), einem Drainbereich (1, 2), einem zwischen Sourcebereich (4) und Drainbereich (1, 2) vorgesehenen Kanalbereich (3) und einem im Abstand über dem Kanalbereich (3) angeordneten isolierten Gate (8),
**dadurch gekennzeichnet, daß**
der Sourcebereich (4) aus einem Material besteht, dessen Bandlücke kleiner ist als diejenige des Materials des Kanalbereiches (3).

2. Halbleiter-Leistungsbauelement nach Anspruch 1,
**dadurch gekennzeichnet, daß**
die Bandlücke des Materials des Sourcebereiches (4) um mindestens 0,1 eV kleiner ist als die Bandlücke des Materials des Kanalbereiches (3).

3. Halbleiter-Leistungsbauelement nach Anspruch 2,
**dadurch gekennzeichnet, daß**
die Bandlücke des Materials des Sourcebereiches um etwa 0,2 eV kleiner ist als die Bandlücke des Materials des Kanalbereiches (3).

4. Halbleiter-Leistungsbauelement nach einem der Ansprüche 1 bis 3,
**dadurch gekennzeichnet, daß**
als Materialien für den Kanalbereich (3) und den Sourcebereich (4) eine der folgenden Kombinationen gewählt ist: Si und SiGe, Si und InAs, Si und InSb, SiGe und Ge, Ge und GeSn, GaAs und Ge, InP und GeSn, InP und InGaAs, InP und PbS, SiC und Si sowie InAs und PbSnSe.

5. Halbleiter-Leistungsbauelement nach einem der Ansprüche 1 bis 4,
**dadurch gekennzeichnet, daß**
es ein n-Kanal-MOS-Feldeffekttransistor oder ein entsprechender IGBT ist.
